# EUROPEAN PATENT APPLICATION

(11) **EP 1 696 661 A2**
(43) Date of publication of application: **30.08.2006**
(21) Application number: 06251010.2
(22) Date of filing: 24.02.2006
(51) Int. Cl.: H04N 5/33, H01L 27/146

(54) **Enhanced spectral range imaging sensor**

(30) Priority: 24.02.2005 GB 0503827
(71) Applicant: E2V Technologies (UK) Limited, Chelmsford, Essex CM1 2QU (GB)
(72) Inventor: Hazelwood, Michel John, Shottisham Woodbridge Suffolk IP12 3ET (GB); Weatherup, Cliff, Chelmsford Essex CM1 2QE (GB)
(74) Representative: Lloyd, Patrick Alexander Desmond

(57) **Abstract**

An imaging sensor comprising a substrate having a light sensitive region and an array of electrodes defining a plurality of pixels, wherein the imaging sensor further comprises a layer of an upconverter material, is provided. The sensor may be used in an imaging device capable of detecting light at wavelengths longer than 1064nm. The imaging device may also simultaneously detect visible light.

## Description

This invention relates to charge coupled devices (CCD's) used as imaging sensors, and in particular to devices having an extended spectral range.

The electronic structure of semiconductor materials comprises two distinct energy bands - the valence band and the conduction band. These bands are separated by an energy gap or bandgap, *E*_{*g*}*,* in which, generally speaking, there are no electron energy states. This is therefore also known as the "forbidden gap". In order to conduct, electrons in the valence band, must somehow be promoted into the conduction band. This may be done, by providing the electrons with enough energy to jump the gap, for example, either optically or thermally. If the stimulation provided is optical, an incoming photon with an energy equal to or greater than that of the bandgap, *E*_{*p*} ∃ *E*_{*g*} can be detected, since if electrons are promoted into the conduction band, a current will flow. The material may then be used as a sensor for light of wavelength, X, where X = *hc*/*E*_{*g*} and *h* and *c* are Planck's constant and the speed of light, respectively.

Consequently, for sensors used in imaging applications, the spectral range of the sensor has a lower wavelength limit defined by *E*_{*g*}.

Sensors and imaging devices comprising CCD devices are well known. A basic CCD device comprises a large array of closely-spaced MOS diodes on a continuous insulator (oxide) layer which covers a semiconductor substrate. In use, a potential distribution is induced in one of the MOS devices, such that minority carriers are transferred from the central electrode of the MOS device to either the right- or lefthand electrode, depending on the direction of current flow.

This transfer process can be repeated by suitable biasing, resulting in the charge being transferred along the array.

The surface of the CCD device is also broken down into pixels, and each pixel is capable of detecting photons.

One particular type of CCD is an electron multiplying CCD, as described in EP-A-0,866,501. In this CCD device, a multiplication register is used to amplify the charge stored in an output register, based on impact ionisation. This arrangement is extremely effective, and can produce very high gains with sub-electron readout noise. Consequently, this device is suitable for use at very low incident light levels.

However, although in general such CCD devices are sensitive, their spectral range is limited, and difficulties occur when trying to image at either the short- or long-wavelength end of the spectrum.

The spectral range of a sensor to high energy photons - the short wavelength end of the spectrum - can be extended by the use of materials which convert the incident photons into lower energy photons. For example, phosphor-based materials and scintillators may be used to convert X-ray photons into visible photons, enabling them to be detected using conventional CCD devices. This is commonly used in dental and medical imaging. However, a single X-ray photon may generate hundreds of visible photons, merely enabling the imaging sensor to be able to perform well at high signal levels. Conventional CCD devices are able to cope well under such operating conditions.

However, attempting to detect low energy photons is also problematic. In particular, imaging in the infrared region of the spectrum is especially difficult.

There is therefore a need to the sensitivity of CCD devices to infrared and other low energy photons.

Materials such as phosphors do respond to low energy photons in the near infrared band, typically 700-1800nm, and some of them will re-emit photons in the range in which the CCD sensor is sensitive. It is therefore possible to use such phosphors or similar material to give sensitivity to photons in the near infrared region. Such materials can be called upconvertors.

The invention in its broadest form provides a CCD imaging device having an extended spectral range.

The invention provides an imaging sensor comprising a substrate having a light sensitive region and an electrode array, comprising a plurality of electrodes being arranged on the light sensitive region to define a plurality of pixels, and layer of an upconverter material, the upconverter material being distributed on the sensor such that the amount of light entering the sensor is controlled.

The layer of the upconverter material may be provided on the light sensitive region adjacent the electrode array. Light entering the sensor may be incident on the upconverter material or on the light sensitive region. The layer of upconverter material may cover at least a portion of the region of the sensor on which it is provided.

The layer of upconverter material may be provided as a continuous layer or may be provided as a patterned layer. At least one of the pixels defined by the electrodes of the a electrode array may be exposed to light incident on the sensor.

In another aspect, the invention provides an imaging sensor comprising a substrate having a light sensitive region and an electrode array comprising a plurality of electrodes arranged on the light sensitive region to define a plurality of pixels and a layer of an upconverter material distributed on a face of the light sensitive region opposite the face of the light sensitive region on which light entering the sensor is incident.

In another aspect, the invention provides an imaging sensor comprising a substrate having a light sensitive region and an electrode array comprising a plurality of electrodes arranged on the light sensitive region to define a plurality of pixels and a layer of an upconverter material, the upconverter material being distributed on the sensor such that a portion of light entering the sensor is incident on the upconverter material and a portion of the light entering the sensor is incident on the light sensitive region.

In each aspect of the invention, the substrate of the imaging sensor may be back thinned. This gives the advantage of improving the quantum efficiency. If the substrate layer is back thinned, a support substrate may be provided.

The imaging sensor may also further comprise a reflective layer adjacent the upconverter layer.

The imaging sensor may also further comprise a filter layer. The filter layer may be provided adjacent the electrode array.

The upconverter material may be an anti-Stokes phosphor or a storage phosphor. The phosphor may be a rare earth phosphor.

In use, the imaging sensor may be continuously charged, or charged only before exposure to incident light. The sensor may be charged by exposure to UV wavelength light.

In use, the imaging sensor may detect at least one of IR and visible wavelength light. IR and visible light may be detected simultaneously.

The imaging sensor may also comprise a multiplication register for multiplying charge accumulated in the pixel array.

The invention also provides an imaging device comprising an imaging sensor in accordance with the present invention.

Embodiments of the invention will now be described by way of example only and with reference to the following drawings in which:
Figure 1 is a schematic diagram of common upconversion mechanisms as might apply in anti-Stokes phosphors;
Figure 2 is as schematic cross-section diagram of a first example of the basic concept of an imaging sensor embodying the present invention;
Figure 3 is a schematic cross-section diagram of a second example of the basic concept of an imaging sensor embodying the present invention;
Figures 4a and 4b are schematic cross-section diagrams of a third example of the basic concept of an imaging sensor embodying the present invention;
Figures 5a and 5b are schematic cross-section diagrams of a fourth example of the basic concept of an imaging sensor embodying the present invention;
Figure 6a illustrates an example of a front illuminated coated imaging sensor embodying the present invention;
Figure 6b illustrates an example of a back illuminated coated imaging sensor embodying the present invention;
Figure 7a illustrates an example of a front illuminated coated constantly charged imaging sensor embodying the present invention;
Figure 7b illustrates an example of a back illuminated coated constantly charged imaging sensor embodying the present invention; and
Figure 8 is a schematic diagram of a CCD imaging device suitable for use with the present invention.

The inventors have appreciated that it is possible to increase the sensitivity of CCD imaging sensors by providing a coating of an upconverter material on one surface of the sensor. Upconverter materials can combine the energy of two or more low-frequency photons (for example, infrared) to produce a single, higher frequency photon (for example, visible). This higher frequency photon may be detected more easily.

Upconversion occurs when a material possesses at least two metastable excited electron states. The lower state serves as an excitation reservoir, whilst the upper serves as the emitting state. Phosphor-based upconverter materials can be classed as either anti-Stokes phosphors or storage phosphors.

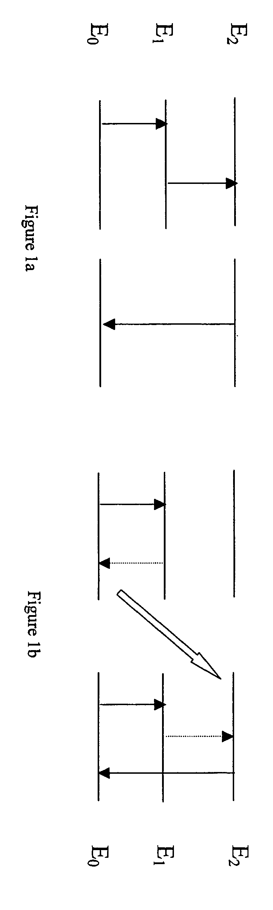

The two anti-Stokes upconversion mechanisms are illustrated in Figure 1.

Firstly, as shown in Figure 1a, ground state absorption of one low energy photon, causing an electron to be promoted form the ground state to the first excited state (*E*_{*0*} - *E*_{*1*}), followed by excited state absorption of a second low energy photon, causing an electron to be promoted to the highest energy state (*E*_{*1*} - *E*_{*2*}), may occur. This is followed by emission of a higher energy photon by an electron transfer from E₂ to E₀.

Secondly, as shown in Figure 1b, low energy photons may be absorbed in two ground state absorptions on neighbouring ions (2*E*_{*0*} - *2E*_{*1*}), followed by an energy transfer upconversion step (*E*_{*1*} *- E*_{*2*}). A higher energy photon, *E*_{*p*} = *E*_{*2*} *- E*_{*0*} is then emitted.

Rare earth ions and some transition metal ions are able to provide a number of these metastable states to enable upconversion to take place. For example, Ti²⁺, Ni²⁺, Mo³⁺, Re⁴⁺, Os⁴⁺, Er³⁺ and Yb³⁺ are often used as dopants in glasses, sol gels and crystal lattice hosts.

Materials known as storage phosphors are also often used as upconverter materials, for example, in laser and X-ray sensing applications. The phosphor is "charged" when short wavelength "charging" photons from an illuminator are incident on the material, typically short visible or UV wavelength light. Absorption of the short wavelength photons causes excitation of electrons within the material to a higher energy state. These electrons then remain in this high energy state until lower wavelength light is incident on the material ("excitation" photons); at which point, the electrons decay back to a lower energy state, emitting emission photons. These emission photons are then detected. Such materials appear to have broader excitation band or state than the anti-Stokes phosphors described above. The decay time of the phosphor is dependent on the flux of excitation photons.

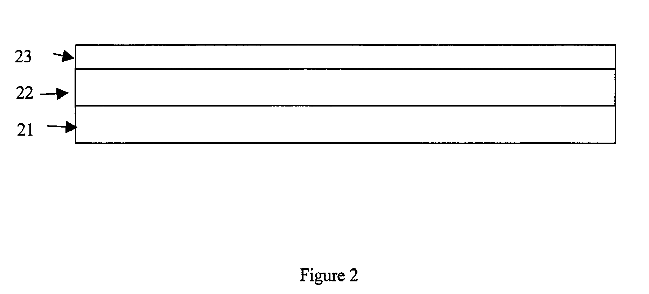

Figure 2 shows a schematic cross-section of a first example of the basic concept of an imaging sensor embodying the present invention. A semiconductor substrate 21, typically silicon, having a light sensitive region, has an array of electrodes 22 on one face (the front side), forming a CCD device. This device is coated with a layer of an upconverter material 23 to form an imaging sensor. This upconverter material may be a rare earth oxysulphide phosphor, sensitive to wavelengths greater than 1064nm, the limit detectable with conventional silicon-based CCD devices. The upconverter material may also be chosen for its physical properties, for example, allowing photon combination in the sub 200nm to 1064nm range, with particular sensitivity above 900nm, and in particular, at around 550nm. For certain applications, however, it may be desired to use an upconverter material that is sensitive to wavelengths below 1064nm.

In use, low-energy incident photons strike the upconverter material, where one of the upconversion processes discussed above occurs, resulting in the material emitting photons of a higher energy and shorter wavelength. For example, absorption of infrared wavelengths may result in the emission of visible wavelengths. These short wavelengths fall within the spectral range of a conventional CCD device, and are detected in the usual manner.

Consequently, the spectral range of the sensor is extended beyond that normally achievable to allowing imaging in the near infrared band of the electromagnetic spectrum.

To achieve this, the layer of upconverter material may be provided on one face of a light sensitive region in a substrate, for example a silicon substrate. The layer is provided adjacent the array of electrodes that defines a plurality of pixels. These pixels are potential wells, which isolate incident photons. The light entering the sensor may either be incident directly onto the upconverter material (the light incident on the "front face") or directly onto the light sensitive region (the light is incident on the "back face"). The upconverter material may be patterned, such that a portion of the light entering the sensor is incident on the light sensitive region and a position is incident on the upconverter material. This patterning is described in more detail below.

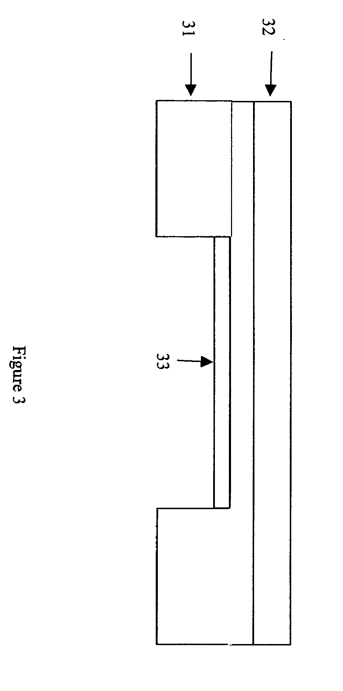

Figure 3 shows a schematic cross-section of a second example of the basic concept of an imaging sensor embodying the present invention. In this sensor, the substrate 31 has been back thinned to improve quantum efficiency (the ratio between the number of photons arriving at the sensor and the number of electrons generated in the pixel. Typically, this ratio is around 45%. In this embodiment, the CCD is made on a silicon wafer, which has a 20µm thick p-doped layer on the front face. The structures on the front face are formed by depositing and etching polycrystalline silicon. These are not totally transparent to electrons, hence the drop in quantum efficiency. The back face of the wafer is mechanically and chemically processed to remove the silicon substrate (but retaining the p-doped layer), the light is able to reach the pixels more easily. This increases the quantum efficiency to around 90%. In order to support this structure, a further silicon superstrate or support substrate is fixed to the front face, by gluing, for example.

The upconverter coating 33 is applied to the back-thinned region. This again results in a sensor which can image at wavelengths greater than 1064nm, beyond those possible with conventional silicon-based CCD sensors.

If the upconverter material is placed on the original front face, then near infra-red photons may be collected, but additional visible photons arriving via the back face are not blocked.

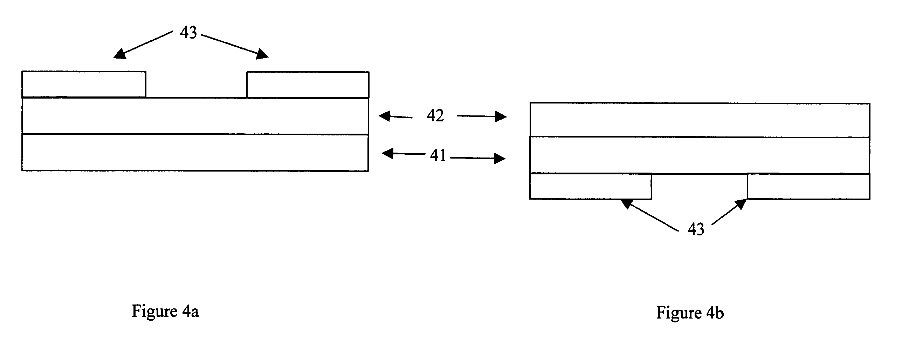

The sensor may also be passivated, by the addition of a thin A1 layer or sheet. Figure 4 shows a schematic cross-section of a third example of the basic concept of an imaging sensor embodying the present invention. In Figure 4a, the upconverter material 43 is coated onto the electrode array 42 on the front face of the substrate 41. The upconverter material 43 is coated in a pattern to allow a controlled portion of visible light to enter the light sensitive region. The pattern may be provided using, for example, screen printing or brush printing methods. In figure 4b,the upconverter material is applied in a pattern to the back face of the substrate.

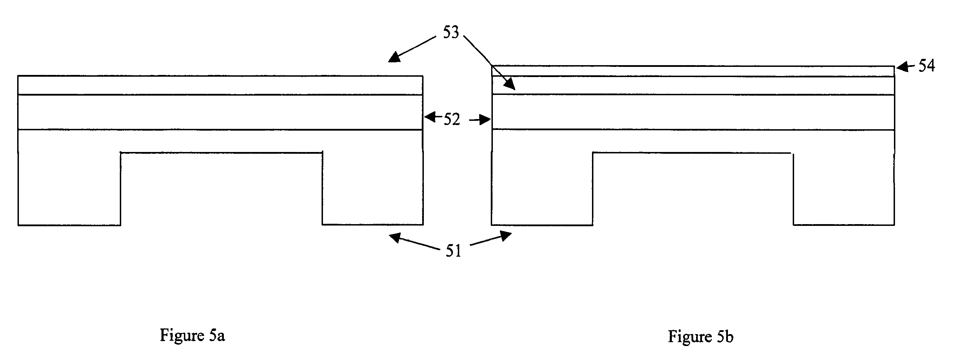

Figure 5 shows a schematic cross-section of a fourth example of the basic concept of an imaging sensor embodying the present invention. In Figure 5a, the upconverter material 53 is coated onto the front face of the sensor, and the back face subsequently thinned. This allows photons in the visible spectrum passing through the thinned back face to be detected directly. Longer wavelength light, (lower energy photons) are passed though the pixels to the upconverter material, where they are converted to higher energy photons. These photons are emitted from the upconverter material, and are then detected by the same sensor.

In Figure 5b, an additional reflective layer is placed behind the upconverter material and the electrode array. One way in which this could be done is to place the layer on the upconverter layer on the face opposite to the gate electrode array. This directs additional photons back into the pixel array, increasing the sensitivity of the sensor. A thin film or aluminium, or other metal with similar reflective properties forms a suitable reflective layer.

In each of the sensors shown in Figures 2 to 5a, 5b, a patterned coating of upconverter material is used. The surface of the sensor exposed to incident light is therefore not completely covered by the upconverter material. The number of pixels, or pixel area left exposed (remaining uncovered) may be chosen depending upon the intended use for the CCD imaging sensor.

Only coating part of the surface of the CCD imaging sensor produces an increase in the sensitivity of the sensor to near IR wavelength incident light, due to the presence of the upconverter material, as well as maintaining the sensor's sensitivity to visible light, due to leaving a number of pixels or pixel areas.

This arrangement therefore enhances the performance of the sensor under a large number of operating conditions. For example, it may be desirable to produce a sensor where the majority of the surface is covered by the upconverter material, and relatively few pixels remain exposed to any incident visible wavelength light. Alternatively, it may be desired to use a small amount of the upconverter material to enhance the signal produced under particular lighting conditions.

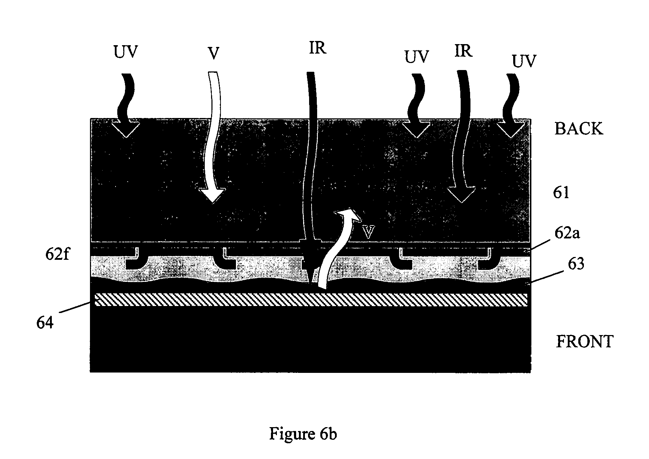

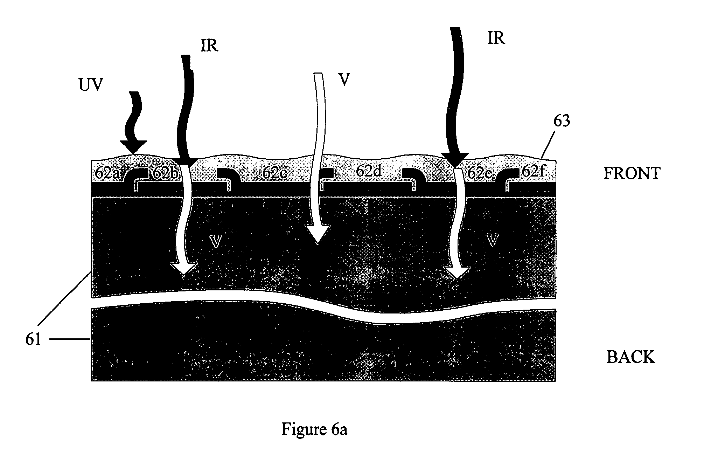

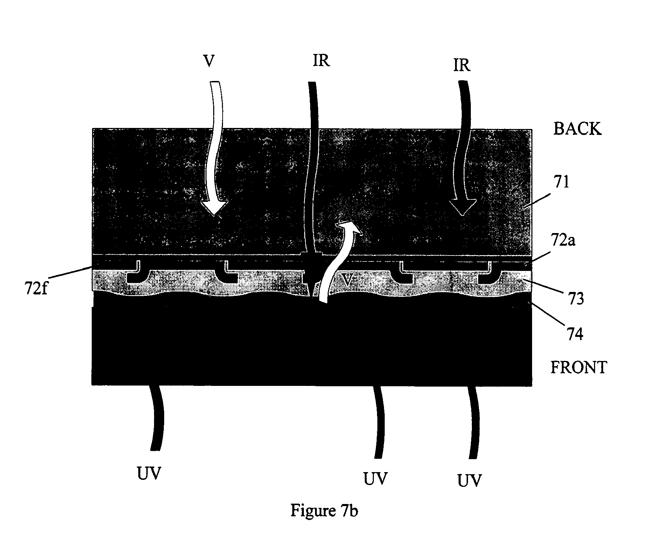

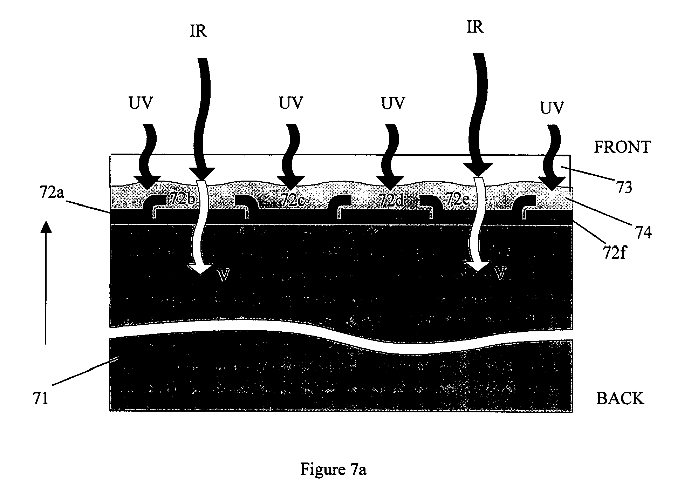

Figures 1 to 5 illustrate the basic concept of applying an upconverter coating to an imaging sensor. However, Figures 6a, 6b, 7a and 7b illustrate actual examples of a CCD imaging sensor which utilises a storage phosphor upconverter coating. In each of these figures, UV wavelength light is represented as an arrow marked "UV", visible wavelength light as an arrow marked "V", and near IR wavelength light as an arrow marked "IR". One difficulty in using a storage phosphor coating with a real-time imaging sensor is preventing the charge illumination from overloading the sensor. The sensors of Figures 6a, 6b, 7a and 7b illustrate how this problem may be overcome.

Figures 6a and 6b illustrate a sensor in which UV illumination is used to charge the storage phosphor before use. UV wavelength light is used to charge the phosphor, by exciting electrons into a higher energy state.

In Figure 6a, a substrate 61 has a layer of gate electrodes 62a to 62f arrayed on its front face. A layer of storage phosphor material 63 is deposited on the gate electrodes 62a - 62f, which is charged by UV illumination incident on the front face of the imaging sensor. In use, visible and near IR wavelength light is incident on the front face of the imaging sensor.

In this example, the near IR wavelength light incident on the storage phosphor acts as excitation photons, causing the electrons previous excited by the UV charging photons to decay. The photons emitted, which produce visible wavelength light, are detected by the electrode array, producing a signal.

In Figure 6b, the CCD imaging sensor is illuminated from the back. Again, the substrate 61 supports an array of gate electrodes 62a - 62f. In this example, the sensor additionally includes a reflective layer 64 positioned between the front of the sensor and the phosphor layer 63. This acts to reflect the visible wavelength light produced by the phosphor back onto the electrode array 62a - 62f to produce a signal in the sensor.

In both Figures 6a and 6b, the charging photon illumination of the sensor is in phase with a single frame of the sensor. This may be constant or pulsed. This overloaded frame is then discarded from the output image stream. Typically, a PAL standard analogue video signal has 50 fields per second interlaced to give 25 frames per second. If pulsed illumination is used, the loss of one frame in five would be acceptable. However, the phosphor response changes with a decay rate dependent on the illumination from the scene viewed by the sensor. The stability of the video image would therefore be scene dependent and might appear to flicker at the charging rate. Nevertheless, such a system would still operate with an enhanced spectral range, and be of much practical use.

Figures 7a and 7b illustrate example sensors where the UV illumination of the phosphor layer is constant, and hence the layer is continuously charged.

Figure 7a again shows front illumination of a CCD imaging sensor having a storage phosphor coating. A substrate 71 supports an array of electrodes 72a - 72f.

A layer of storage phosphor 73 is uppermost on the sensor. However, as the sensor is being constantly charged, it is necessary to provide a filter 74, between the phosphor 73 and the array of electrodes 72a - 72f, to prevent any UV wavelength light form passing through the phosphor 73 and being detected by the electrode array 72a -72f during use. A suitable filter material prevents light of wavelength below 400nm from being passed to the gate electrode array 72a - 72f.

Figure 7b illustrates back illumination of a constantly charged CCD imaging sensor having a storage phosphor coating. This is similar to Figure 7a, except that although the near IR and visible wavelength light which is to be detected is incident on the back side of the sensor, the UV charging illumination is incident on the front side of the sensor. An appropriate filter layer to prevent UV light reaching the light sensing area may be used as necessary.

Figure 7a and 7b offer a second approach, wherein a filter is used to screen the sensor from the charging illumination. This may be in the form of a specific structure added after manufacture of the basic underlying CCD device, or may be provided as part of the manufacturing process of the CCD device. An exemplary filter blocks light below 400nm. An illuminator with a wavelength below this wavelength, for example at 375nm would produce no detectable signal, either from the areas of the sensor covered by the upconverter material, or from the areas left uncovered, which are still sensitive to visible wavelength light. With this approach, it is therefore possible to illuminate and charge the phosphor in every frame of the video stream, without overloading the sensor. This would give a consistent and stable response, largely independent of the scene illumination. Again, the illumination may be continuous or pulsed.

For phosphor materials with a response in the region of 900nm, the QE of the sensor is around 30%-40%. However, the QE of the device at around 1064nm drops rapidly as the wavelength increases, to 0.5% for a front illuminated device. By using a phosphor to convert radiation at 1064nm to 600nm, it is possible to obtain an effective QE greater than that for the sensor alone. For example, if a storage phosphor converts photons from 1064nm to 600nm with an efficiency of 25%, the combined with a CCD having a QE of 40%, the effective QE at 1064nm becomes 10%, twenty times better than the CCD alone at 1064nm.

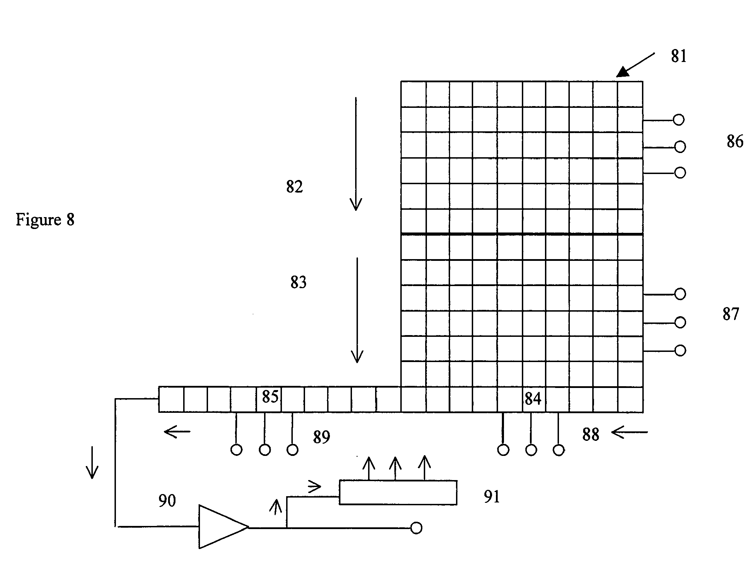

Figure 8 shows a schematic diagram of a CCD imaging device suitable for use with the upconverter coating described above. CCD devices with multiplication registers, such as that described in EP-A-0,866,501, are particularly suitable for use in low incident light operating conditions.

In the CCD imaging device 81, charge is accumulated in the pixel area 82. The amount of charge stored is indicative of the amount of radiation incident on the pixels. The charge is transferred to a storage section 83, and then to an output register 84. This is done on a row-by-row basis, by applying suitable drive pulses to electrodes 85 and 86. Drive pulses from electrodes 87 and 88 are used to transfer the signal charge in the output register 84 to a multiplication register 89. Charge transfer is in the direction shown by the arrows.

One or more drive pulses applied to the electrodes 87 and 88 are of a sufficiently large amplitude that high field regions are produced in the register 89. These fields produce impact ionisation within the register 89, causing signal multiplication. The signal charge is detected at charge detection circuit 90, which includes a gain control, 91. This results in low-noise amplification of the signal charge.

It is also possible to use such a multiplication system in a CCD imaging device where the store 83 is omitted.

Coating a CCD imaging device which comprises a multiplication register with an upconverter material results in a sensor with an extended spectral range which is able to operate even in minimum incident light conditions.

Although embodiments of the invention have been described with respect to CCD imaging devices, it would be possible to apply an upconverter coating to other imaging which would need to be cooled to reduce dark current, and a long integration time would be necessary. It may also be possible to use CMOS sensors or avalanche photodiodes.

Various other modifications are possible and will occur to those skilled in the art without departing from the scope of the invention which is defined by the following claims.

## Claims

1. An imaging sensor comprising a substrate having a light sensitive region and an electrode array comprising a plurality of electrodes arranged on the light sensitive region to define a plurality of pixels, a layer of upconverter material distributed on the sensor, and a multiplication means for multiplying charge accumulated in the electrode array.

2. A sensor array according to claim 1, wherein the upconverter material is an anti-stokes phosphor.

3. A sensor array according to claim 1, wherein the upconverter material is a storage phosphor.

4. An imaging sensor comprising a substrate having a light sensitive region and an electrode array comprising a plurality of electrodes arranged on the light sensitive region to define a plurality of pixels, and a layer of storage phosphor distributed on the sensor and acting as a upconverter material.

5. An imaging sensor comprising a substrate having a light sensitive region and an electrode array comprising a plurality of electrodes being arranged on the light sensitive region to define a plurality of pixels, and a layer of an upconverter material, the upconverter material being distributed on the sensor such that the amount of light entering the sensor is controlled.

6. The imaging sensor of claim 6, wherein the layer of upconverter material is provided on the light sensitive region adjacent the electrode array.

7. The imaging sensor of claim 6, wherein the upconverter material is arranged such that, in use, light entering the sensor is incident on the upconverter material.

8. The imaging sensor of claim 6, wherein the upconverter material is arranged such that, in use, light entering the sensor is incident on the light sensitive region.

9. The imaging sensor of any of claims 5 to 8, wherein the layer of upconverter material covers at least a portion of the structure.

10. The imaging sensor of claim 9, wherein the layer of upconverter material is a continuous layer.

11. The imaging sensor of claim 9, wherein the upconverter material is a patterned layer.

12. The imaging sensor of any of claims 5 to 9, wherein, in use, at least one of the pixels defined by the electrode array is exposed to light incident on the sensor.

13. An imaging sensor comprising a substrate having a light sensitive region and an electrode array comprising a plurality of electrodes and arranged on the light sensitive region to define a plurality of pixels, and a layer of an upconverter material distributed on a face of the light sensitive region opposite the face of the light sensitive region where light entering the sensor is incident.

14. An imaging sensor comprising a substrate having a light sensitive region and an electrode array comprising a plurality of electrodes being arranged on the light sensitive region to define a plurality of pixels, and a layer of an upconverter material, the upconverter material being distributed on the sensor such that a portion of the light entering the sensor is incident on the upconverter material and a portion of the light entering the sensor is incident on the light sensitive region.

15. The imaging sensor of any preceding claim, wherein the layer of material having a light sensitive region is back thinned.

16. The imaging sensor of claim 15, further comprising a support supersubstrate to support the back-thinned substrate.

17. The imaging sensor of any of preceding claim further comprising a reflective layer adjacent the upconverter layer.

18. The imaging sensor of any preceding claim further comprising a filter layer.

19. The imaging sensor of claim 18, wherein the filter layer is provided adjacent the electrode array.

20. The imaging sensor of any preceding claim, where the upconverter material is an anti-Stokes phosphor.

21. The imaging sensor of any of claims 1 to 19, wherein the upconverter material is a storage phosphor.

22. The imaging sensor of claim 19 or 21, wherein the phosphor is a rare earth phosphor.

23. The imaging sensor of claim 21, wherein in use, the imaging sensor is continuously charged.

24. The imaging sensor of claim 21, wherein in use, the imaging sensor is charged only before exposure to incident light.

25. The imaging sensor of claim 23 or 24, wherein the sensor is charged by exposure to UV wavelength light.

26. The imaging sensor of any preceding claim, wherein in use, the imaging sensor detects IR or visible wavelength light.

27. The imaging sensor of claim 26, wherein in use, the imaging sensor detects IR and visible light simultaneously.

28. The imaging sensor of any preceding claim, comprising a multiplication register for multiplying charge accumulated in the pixel array.

29. An imaging device comprising the imaging sensor of any of claims 1 to 28.
